# EUROPEAN PATENT SPECIFICATION

(11) **EP 3 986 102 B1**
(45) Date of publication and mention of the grant of the patent: **05.06.2024**
(21) Application number: 20868063.7
(22) Date of filing: 22.05.2020
(51) Int. Cl.: H05K 7/20, H04M 1/02

(54) **ELECTRONIC ASSEMBLY AND TERMINAL DEVICE**
ELEKTRONISCHE ANORDNUNG UND ENDGERÄTEVORRICHTUNG
ENSEMBLE ÉLECTRONIQUE ET DISPOSITIF TERMINAL

(30) Priority: 25.09.2019 CN 201910910791
(43) Date of publication of application: 20.04.2022
(73) Proprietor: ZTE Corporation, Shenzhen, Guangdong 518057 (CN)
(72) Inventor: HUANG, Zhulin, Shenzhen, Guangdong 518057 (CN)
(74) Representative: Betten & Resch
(86) International application number: PCT/CN2020/091730
(87) International publication number: WO 2021/057052

(56) References cited:
- WO-A1-2014/196830
- WO-A1-2019/028678
- CN-A- 104 752 808
- CN-A- 104 752 808
- CN-A- 107 732 406
- CN-U- 205 911 423
- US-A1- 2017 077 754
- US-A1- 2018 183 910
- US-A1- 2018 211 150

## Description

### TECHNICAL FIELD

Embodiments of the present application relates to the technical field of electronic devices, in particular to an electronic assembly and a terminal device having the electronic assembly.

### BACKGROUND

With the continuous development of electronic technologies, more and more functions are integrated in various terminal devices. As a common technology for wireless communication, near field communication (NFC) is gradually popularizing in various terminal devices on the market. The NFC communication module integrated in terminal devices enables non-contact point-to-point data transmission between electronic devices by means of electromagnetic field coupling.

However, the application of various technologies and functions leads to the increase of power consumption on terminal devices. In use, the temperature at a local position of a terminal device housing is often too high, which affects the user experience. In order to avoid local overheating of the terminal device housing, a heat conductive material such as a graphite sheet or a copper foil is usually attached to the housing. Due to good heat conductivity of the heat conductive material, heat can be diffused from a higher temperature position on the housing to other lower temperature areas of the housing, achieving the temperature equalization effect. Although the materials such as the graphite sheet and copper foil conduct heat well, they have a shielding effect on the electromagnetic transmission of the NFC communication module. In this way, the design of terminal devices cannot balance temperature equalization and the electromagnetic transmission performance, which has become a major problem in the development of electronic technologies.

US2018/0211150A1 discloses an antenna device, incorporated in an electronic apparatus, which communicates with an external device via an electromagnetic field signal, comprising: an antenna coil provided by winding a conducting wire in a two-dimensional shape and inductively coupled to the external device; and a thermal diffusion sheet provided so as to overlap the antenna coil at a surface of the antenna coil that faces the external device, wherein the thermal diffusion sheet is provided with a slit formed so as to extend from a region overlapping an opening of the antenna coil to an end of the thermal diffusion sheet and a thermal diffusion sheet side opening or slit connected to the slit and formed in the region overlapping the opening of the antenna coil.

WO2019028678A1 discloses an antenna assembly and a terminal. The terminal comprises a non-metal back shell, a main board, a battery, and a coupling coil layer. The inner surface of the non-metal back shell is provided with a heat conductor layer; the heat conductor layer is slotted to form an NFC antenna coil; the main board is disposed opposite to the heat conductor layer, and a feeding point is provided on the main board; the battery and the main board are arranged in a direction parallel to the heat conductor layer; the coupling coil layer is disposed between the main board and the heat conductor layer, and is arranged along with the battery in a direction parallel to the heat conductor layer; the coupling coil layer is connected to the feeding point on the main board; and a space coupling can be formed between the coupling coil layer and the heat conductor layer, so that the heat conductor layer generates secondary radiation.

CN104752808A discloses an NFC antenna assembly, comprising a metal sheet, which is provided with an assembling hole penetrating through the metal sheet; an installation sheet, which is disposed in the assembling hole; an insulation gasket, which is disposed in the assembling hole, and covers the periphery of the installation sheet; and a NFC antenna, which is disposed on the installation sheet, wherein the installation sheet is provided with a first through groove extending along the radial direction of the installation sheet, and the metal sheet is provided with a second through groove extending from the installation hole towards one side edge of the metal sheet. According to the NFC antenna assembly provided by the invention, the installation sheet and the metal sheet are respectively provided with the first through groove and the second through groove, so that less eddy can be generated, and then magnetic lines can be coupled to the metal sheet serving as a passive amplifier, the magnetic flux can be increased while the magnetic line can pass through the assembling hole, the NFC antenna performance is improved, and meanwhile the design philosophy of reducing the size of the NFC antenna assembly is met and the costs can be saved.

US2018/0183910A1 discloses a housing assembly for a terminal and a terminal. The housing assembly includes a housing, an antenna radiator and a ferrite. The antenna radiator is positioned at an outer face of the housing, and has a first orthographic projection region on the outer face. The ferrite is arranged on an inner face of the housing, and has a second orthographic projection region on the outer face. The first orthographic projection region is located in the second orthographic projection region.

### SUMMARY

This object is achieved by an electronic assembly having the features of claim 1 and by a terminal device having the features of claim 9. Preferred embodiments are defined by the dependent claims.

### BRIEF DESCRIPTION OF DRAWINGS

One or more embodiments are exemplified by the pictures in the corresponding drawings. These example descriptions do not constitute a limitation on the embodiments. Elements in the drawings with the same reference numerals are denoted as similar elements. Unless otherwise specified, the pictures in the drawings do not constitute a scale limitation.
FIG. 1 is a schematic stereogram of an electronic assembly according to a first, non-claimed, embodiment of the present application;
FIG. 2 is a schematic structural diagram of a heat conduction plate of the electronic assembly according to the first, non-claimed, embodiment of the present application;
FIG. 3 is a schematic diagram in which a coil shown in FIG. 1 is completely covered by a heat conduction plate without a through-hole;
FIG. 4 is a schematic diagram in which the coil shown in FIG. 1 is completely covered by the heat conduction plate with the through-hole;
FIG. 5 is a schematic diagram in which the coil shown in FIG. 1 is completely covered by the heat conduction plate with the through-hole;
FIG. 6 is a schematic stereogram of an electronic assembly according to a second, non-claimed, embodiment of the present application;
FIG. 7 is a schematic stereogram of an electronic assembly according to a third embodiment of the present application; and
FIG. 8 is a structural composition block diagram of a terminal device according to a fourth embodiment of the present application.

### DETAILED DESCRIPTION

In order to make the objectives, technical schemes and advantages of the embodiments of the present application clearer, a detailed description will be made to the embodiments of the present application below with reference to the accompanying drawings. However, it is to be understood by those having ordinary skill in the art that many technical details are proposed in each embodiment of the present application to enable the reader to better understand the present application. However, the technical schemes claimed in the present application can be achieved even without these technical details and various changes and modifications based on the following embodiments.

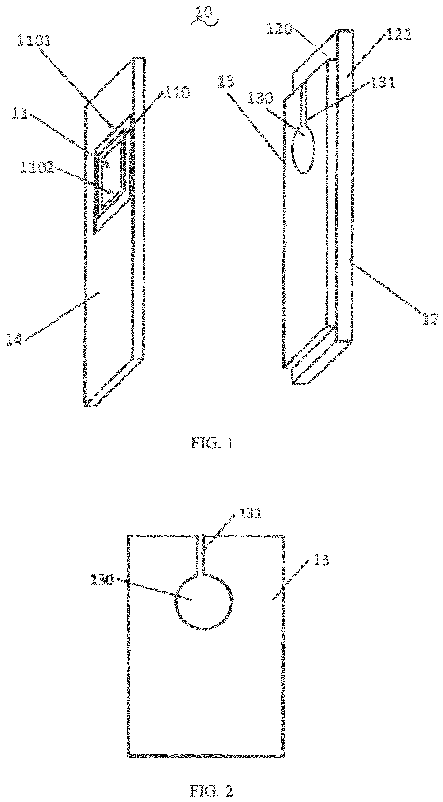

As shown in FIG. 1, a first, non-claimed, embodiment of the present application relates to an electronic assembly 10. In this embodiment, the electronic assembly 10 includes an electromagnetic module 11 and a housing 12 disposed on one side of the electromagnetic module 11, and further includes a heat conduction plate 13 disposed on the housing 12. The heat conduction plate 13 is provided with a through-hole 130 corresponding to the electromagnetic module 11, and a slot 131 penetrating through the heat conduction plate 13 in a thickness direction and communicating the through-hole 130 with an edge of the heat conduction plate 13. Here, the heat conduction plate 13 disposed on the housing 12 has a front surface near the housing 12 and a back surface opposite to the front surface and farther from the housing 12. The so-called "penetrating through the heat conduction plate 13 in a thickness direction of the heat conduction plate 13" means that the slot 131 communicates the front surface and back surface of the heat conduction plate 13.

Since the heat conduction plate of this electronic assembly is provided with the through-hole corresponding to the electromagnetic module and the slot for communicating the through-hole with the edge of the heat conduction plate, the integrity of the heat conduction plate is broken, so that the electromagnetic energy generated by the electromagnetic module is concentrated along the edges of the through-hole and the slot to form a strong electromagnetic effect and ensure the electromagnetic transmission performance. In addition, the heat conduction plate provided with the through-hole and the slot can still cover a large area of the housing, such that the heat can be diffused from a higher-temperature position on the housing to most lower-temperature areas of the housing, thereby achieving a better temperature equalization effect and striking a balance between temperature equalization and the electromagnetic transmission performance.

The implementation details of a non-contact detection device in this embodiment will be described below. The following content is only the implementation details provided for ease of understanding, and not necessary for the implementation of this scheme.

Referring to FIG. 1, the electronic assembly 10 in this embodiment includes an electromagnetic module 11 disposed on a frame 14, a housing 12 and a heat conduction plate 13. The frame 14 is generally a middle frame of an electronic device (such as a mobile phone, a computer, or a tablet), on which a processor, a controller, a circuit board and other devices are disposed. The electromagnetic module 11 located on the frame 14 may be connected to the controller, the processor and so on through the circuit board.

The electromagnetic module 11 is configured to emit electromagnetic energy, so as to enable a non-contact radio frequency identification function of the electronic assembly 10. In this embodiment, the electromagnetic module 11 includes an annular coil 110, i.e., an NFC coil configured to generate an electromagnetic field for near field communication. Generally, NFC coils have different shapes and specifications. They may be circular, rectangular, etc., and an area defined by each NFC coil is usually 400 square millimeters to 1,000 square millimeters. In practical production, the shape and specification of the coil 110 may be flexibly selected according to different structures and parameter design requirements, without specific restrictions. In this embodiment, the coil 110 shown in FIG. 1 is rectangular.

The housing 12 covers and protects the electromagnetic module 11, and the housing 12 may be made of plastic, resin, metal, or the like. In this embodiment, to make local heat quickly diffuse and achieve temperature equalization, the housing 12 adopts a metal housing. The housing 12 has an inner surface 120 facing the electromagnetic module 11 and an outer surface 121 facing away from the electromagnetic module 11 and opposite to the inner surface 120.

The heat conduction plate 13 is disposed on the inner surface 120 of the housing 12. In a general structure of the electronic assembly, since the inner surface 120 of the housing 12 is adjacent to heating units such as batteries or electronic components, such an arrangement can make the heat conduction plate 13 closer to a heat source, which is beneficial to receive heat more directly and quickly diffuse it to various positions of the housing 12. It should be noted that the heat conduction plate 13 may be disposed on the housing 12 in different ways, for example, it can be attached to the inner surface 120, or fixed on the inner surface 120 by a buckle structure, as long as the heat conduction plate 13 can be fixed on the housing 12 and is not easy to fall off.

The heat conduction plate 13 may be a graphite sheet, a copper foil or other materials with good thermal conductivity. In this way, it can receive heat and quickly conduct it to various positions of the housing 12 to achieve a temperature equalization effect. Referring to FIG. 2, the heat conduction plate 13 is provided with a through-hole 130 corresponding to the electromagnetic module 11 and a slot 131 communicating the through-hole 130 with the edge of the heat conduction plate 13, where the slot 131 penetrates through the heat conduction plate 13 in a thickness direction.

Since the through-hole 130 and the slot 131 breaks the integrity of the heat conduction plate 13, the electromagnetic energy generated by the coil 110 can be concentrated along the edges of the through-hole 130 and the slot 131 to form a strong electromagnetic effect, thereby ensuring the electromagnetic transmission performance. In addition, the heat conduction plate 13 provided with the through-hole 130 and the slot 131 can still cover a large area of the housing 12, such that the heat can be diffused from a higher temperature position on the housing 12 to most lower-temperature areas of the housing 12, thereby achieving a better temperature equalization effect and striking a balance between temperature equalization and the electromagnetic transmission performance.

It should be noted that the shape of the through-hole 130 may be square, circular, elliptical, or the like. In one embodiment, the through-hole 130 is circular. The circular through-hole cut in the heat conduction plate 13 can avoid fracture of the plate as the stress generated in the circular through-hole is smaller than that generated in elliptical, polygonal or other-shaped through-holes, thereby prolonging the life and improving the reliability of the heat conduction plate. It should be noted that the size of the through-hole 130 is directly proportional to the electromagnetic transmission performance, and inversely proportional to the temperature equalization effect. Therefore, the size of the through-hole 130 should be set according to the size of the electronic assembly 10, and the requirements on the electromagnetic transmission performance and temperature equalization effect. In one embodiment, the through-hole 130 has a diameter ranging from 15 mm to 25 mm. In another embodiment, the through-hole has a diameter of 20 mm.

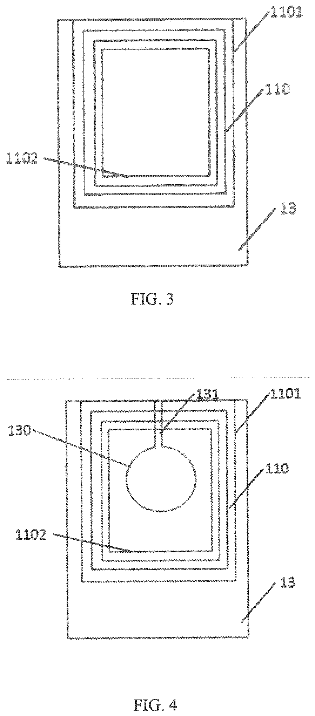

In one embodiment, a geometric center of the through-hole 130 and a geometric center of the coil 110 are directly opposite to each other, that is, an orthographic projection of the geometric center of the through-hole 130 on the housing 12 coincides with that of the coil 110 on the housing 12. In this way, the through-hole 130 can directly face the center of an electromagnetic field generated by the coil 110, such that the intensity of the electromagnetic field concentrated at the edge of the through-hole 130 is more uniform, and the electromagnetic transmission performance is improved. As shown in FIG. 1, the coil 110 has an outer edge 1101 and an inner edge 1102. In one embodiment, the orthographic projection of the through-hole 130 on the housing 12 falls within an orthographic projection of the inner edge 1101 of the coil 110 on the housing 12, as shown in FIG. 4. Such an arrangement can ensure that the size (area) of the through-hole 130 is smaller than the size of the coil 110 (an area enclosed by the outer edge of the coil). Under the premise of ensuring that the electromagnetic transmission performance is not greatly affected, the area of the heat conduction plate 13 can be reserved as much as possible (the smaller the through-hole 130 is, the larger the area of the heat conduction plate 13 is), thereby achieving a better temperature equalization effect.

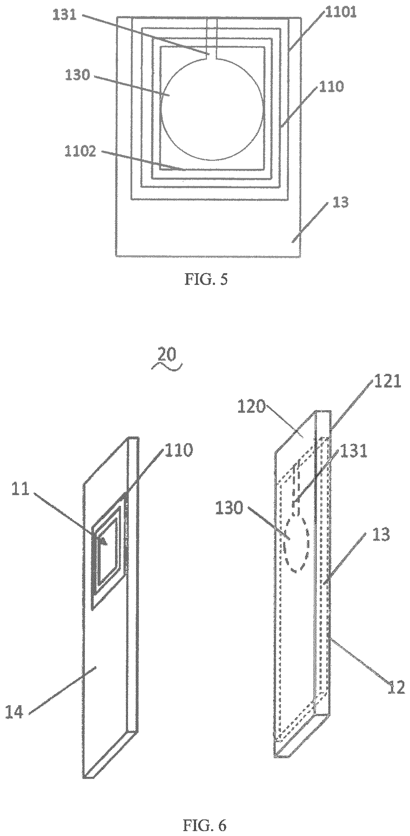

As shown in FIG. 1, the coil 110 has an outer edge 1101 and an inner edge 1102. In one embodiment, the orthographic projection of the inner edge 1102 of the coil 110 on the housing 12 is tangent to the orthographic projection of the edge of the through-hole 130 on the housing, that is, the orthographic projection of the inner edge 1102 of the coil 110 on the housing 12 is internally tangent to the orthographic projection of the edge of the through-hole 130 on the housing 12, as shown in FIG. 5. When they are internally tangent, the electromagnetic transmission performance and the temperature equalization effect can be better balanced.

In one embodiment, the area of the heat conduction plate 13 is large enough to cover the entire coil 110, that is, an orthographic projection of the outer edge 1101 of the coil 110 on the housing 12 falls within an orthographic projection of the heat conduction plate 13 on the housing 12, as shown in FIG. 4 or FIG. 5.

Since the housing 12 covers the electromagnetic module 11 having the coil 110, the heat conduction plate 13 disposed on the inner surface 120 of the housing 12 also covers the coil 110. It should be noted that the attenuation degree of NFC electromagnetic signals generated by the coil 110 is related to the area of the coil covered by the heat conduction plate 13. When the heat conduction plate 13 that covers the entire coil 110 but has no through-hole 130 as shown in FIG. 3 is used, the performance index of NFC nearly drops to 0; and when the heat conduction plate 13 that covers the entire coil 110 and has the through-hole 130 as shown in FIG. 4 or FIG.5 is used, electromagnetic energy can be transmitted through the through-hole 130, instantly enhancing the coupling capability of the NFC electromagnetic field with an electromagnetic field of an external NFC device, so that the operation state of NFC is nearly the same as that before the heat conduction plate 13 is used.

The second, non-claimed, embodiment of the present application relates to another electronic assembly 20. Referring to FIG. 6, the electronic assembly 20 provided by the second, non-claimed, embodiment is substantially the same as the electronic assembly 10 provided by the first, non-claimed, embodiment. The electronic assembly 20 provided by the second, non-claimed, embodiment also includes an electromagnetic module 11, a housing 12, and a heat conduction plate 13. The difference is that the heat conduction plate 13 (shown in dashed lines) of the second, non-claimed, embodiment is embedded in the housing 12 and located between the inner surface 120 and the outer surface 121.

In this way, the heat conduction plate 13 and the housing 12 appear as a whole, improving the integrity of appearance. In addition, the embedded heat conduction plate 13 can increase the strength of the housing 12, such as the compression resistance and bending resistance, thereby prolonging the service life of the housing 12.

It should be noted that the design schemes such as the structures and materials of all components provided in the first, non-claimed, embodiment of the present application may also apply to the electronic assembly 20 provided in the second, non-claimed, embodiment, and are not repeated here.

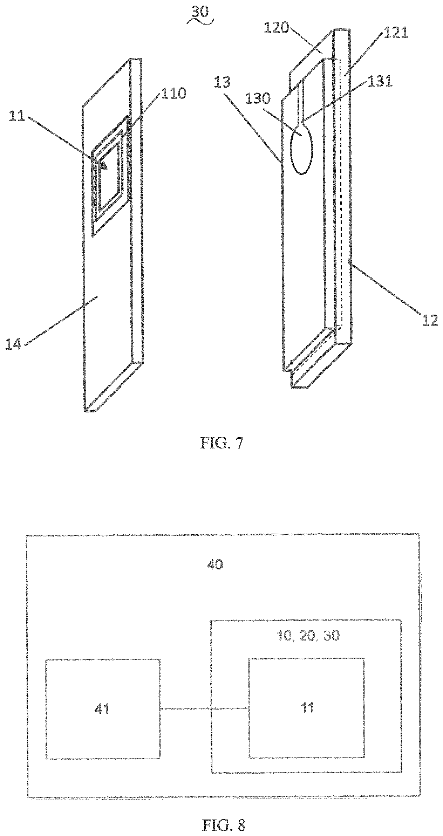

A third embodiment of the present application relates to another electronic assembly 30. Referring to FIG. 7, the electronic assembly 30 provided by the third embodiment is substantially the same as the electronic assembly 10 provided by the first, non-claimed, embodiment. The electronic assembly 30 provided by the third embodiment also includes an electromagnetic module 11, a housing 12, and a heat conduction plate 13. The difference is that a part of the heat conduction plate 13 of the third embodiment is embedded in the housing 12 and located between the inner surface 120 and the outer surface 121, and the other part of the heat conduction plate 13 is exposed from the inner surface 120 and located between the electromagnetic module 11 and the inner surface 120.

In this way, the heat conduction plate 13 and the housing 12 appear as a whole, improving the integrity of appearance. In addition, the embedded heat conduction plate 13 can increase the strength of the housing 12, such as the compression resistance and bending resistance, thereby prolonging the service life of the housing 12.

It should be noted that the design schemes such as the structures and materials of all components provided in the first, non-claimed, embodiment of the present application may also apply to the electronic assembly 30 provided in the third embodiment, and are not repeated here.

A fourth embodiment of the present application relates to a terminal device 40 as shown in FIG. 8. The terminal device 40 includes a battery 41, and the electronic assembly 10 as described in the first, non-claimed, embodiment or the electronic assembly 20 as described in the second, non-claimed, embodiment or the electronic assembly 30 as described in the third embodiment, where the battery 41 is electrically connected to the electromagnetic module 11, and the housing of the electronic assembly 10, the electronic assembly 20 or the electronic assembly 30 covers the battery 31.

## Claims

1. An electronic assembly (10), comprising:
an electromagnetic module (11),
a housing (12) disposed on one side of the electromagnetic module (11), and
a heat conduction plate (13), wherein the heat conduction plate (13) is provided with a through-hole (130) corresponding to the electromagnetic module (11), and a slot (131) penetrating through the heat conduction plate (13) in a thickness direction and communicating the through-hole (130) with an edge of the heat conduction plate (13);
**characterized in that** the housing (12) comprises an inner surface (120) facing the electromagnetic module (11) and an outer surface (121) facing away from the electromagnetic module (11) and opposite to the inner surface (120); a part of the heat conduction plate (13) is embedded in the housing (12) and located between the inner surface (120) and the outer surface (121); and the other part of the heat conduction plate (13) is located between the inner surface (120) and the electromagnetic module (11).

2. The electronic assembly (10) of claim 1, wherein the electromagnetic module (11) comprises an annular coil (110) configured to generate an electromagnetic field, and a geometric center of the coil (110) is directly opposite that of the through-hole (130).

3. The electronic assembly (10) of claim 2, wherein an orthographic projection of the through-hole (130) on the housing (12) falls within an orthographic projection of an inner edge of the coil (110) on the housing (12).

4. The electronic assembly (10) of claim 3, wherein the orthographic projection of the inner edge of the coil (110) on the housing (12) is tangent to an orthographic projection of an edge of the through-hole (130) on the housing (12).

5. The electronic assembly (10) of claim 2, wherein an orthographic projection of the outer edge of the coil (110) on the housing (12) falls within an orthographic projection of the heat conduction plate (13) on the housing (12).

6. The electronic assembly (10) of claim 1, wherein the through-hole (130) has a circular shape.

7. The electronic assembly (10) of claim 6, wherein the through-hole (130) has a diameter ranging from 15 mm to 25 mm.

8. The electronic assembly (10) of claim 7, wherein the through-hole (130) has a diameter of 20 mm.

9. A terminal device (40), comprising a battery (41) and the electronic assembly (10) of any one of claims 1 to 8, wherein the battery (41) is electrically connected to the electromagnetic module (11), and the housing (12) covers the battery (41).

## Patentansprüche

1. Elektronische Anordnung (10), umfassend:
ein elektromagnetisches Modul (11),
ein Gehäuse (12), das auf einer Seite des elektromagnetischen Moduls (11) angeordnet ist, und
eine Wärmeleitplatte (13), wobei die Wärmeleitplatte (13) mit einem Durchgangsloch (130) entsprechend dem elektromagnetischen Modul (11) und einem Spalt (131) versehen ist, der die Wärmeleitplatte (13) in einer Dickerichtung durchdringt und das Durchgangsloch (130) mit einer Kante der Wärme leitplatte (13) verbindet;
**dadurch gekennzeichnet, dass** das Gehäuse (12) eine innere Oberfläche (120), die dem elektromagnetischen Modul (11) zugewandt ist, und eine äußere Oberfläche (121) umfasst, die von dem elektromagnetischen Modul (11) abgewandt und gegenüber der inneren Oberfläche (120) ist; ein Teil der Wärmeleitplatte (13) in dem Gehäuse (12) eingebettet ist und sich zwischen der inneren Oberfläche (120) und der äußeren Oberfläche (121) befindet; und der andere Teil der Wärmeleitplatte (13) sich zwischen der inneren Oberfläche (120) und dem elektromagnetischem Modul (11) befindet.

2. Elektronische Anordnung (10) nach Anspruch 1, wobei das elektromagnetische Modul (11) eine Ringspule (110) umfasst, die dazu konfiguriert ist, ein elektromagnetisches Feld zu erzeugen, und ein geometrisches Zentrum der Spule (110) direkt gegenüber dem Durchgangsloch (130) ist.

3. Elektronische Anordnung (10) nach Anspruch 2, wobei eine orthografische Projektion des Durchgangslochs (130) auf das Gehäuse (12) in eine orthografische Projektion einer inneren Kante der Spule (110) auf das Gehäuse (12) fällt.

4. Elektronische Anordnung (10) nach Anspruch 3, wobei die orthografische Projektion der inneren Kante der Spule (110) auf das Gehäuse (12) zu einer orthografischen Projektion einer Kante des Durchgangslochs (130) auf das Gehäuse (12) tangential ist.

5. Elektronische Anordnung (10) nach Anspruch 2, wobei eine orthografische Projektion der äußeren Kante der Spule (110) auf das Gehäuse (12) in eine orthografische Projektion der Wärmeleitplatte (13) auf das Gehäuse (12) fällt.

6. Elektronische Anordnung (10) nach Anspruch 1, wobei das Durchgangsloch (130) eine kreisförmige Form hat.

7. Elektronische Anordnung (10) nach Anspruch 6, wobei das Durchgangsloch (130) einen Durchmesser hat, der von 15 mm bis 25 mm reicht.

8. Elektronische Anordnung (10) nach Anspruch 7, wobei das Durchgangsloch (130) einen Durchmesser von 20 mm hat.

9. Endgerätevorrichtung (40), umfassend eine Batterie (41) und eine elektronische Anordnung (10) nach einem der Ansprüche 1 bis 8, wobei die Batterie (41) elektrisch mit dem elektromagnetischen Modul (11) verbunden ist, und das Gehäuse (12) die Batterie (41) abdeckt.

## Revendications

1. Un ensemble électronique (10), comprenant :
un module électromagnétique (11),
un boîtier (12) disposé sur un côté du module électromagnétique (11), et
une plaque (13) conductrice de chaleur, la plaque (13) conductrice de chaleur présentant un trou traversant (130) correspondant au module électromagnétique (11), et une fente (131) pénétrant à travers la plaque (13) conductrice de chaleur dans la direction de l'épaisseur et faisant communiquer le trou traversant (130) avec un bord de la plaque (13) conductrice de chaleur ;
**caractérisé en ce que** le boîtier (12) comprend une surface interne (120) tournée vers le module électromagnétique (11) et une surface externe (121) tournée à l'opposé du module électromagnétique (11) et opposée à la surface interne (120) ; une partie de la plaque (13) conductrice de chaleur est intégrée dans le boîtier (12) et située entre la surface interne (120) et la surface externe (121) ; et l'autre partie de la plaque (13) conductrice de chaleur est située entre la surface interne (120) et le module électromagnétique (11).

2. L'ensemble électronique (10) selon la revendication 1, dans lequel le module électromagnétique (11) comprend une bobine annulaire (110) configurée pour générer un champ électromagnétique, et un centre géométrique de la bobine (110) est directement opposé à celui du trou traversant (130).

3. L'ensemble électronique (10) selon la revendication 2, dans lequel une projection orthographique du trou traversant (130) sur le boîtier (12) se situe à l'intérieur d'une projection orthographique d'un bord intérieur de la bobine (110) sur le boîtier (12).

4. L'ensemble électronique (10) selon la revendication 3, dans lequel la projection orthographique du bord intérieur de la bobine (110) sur le boîtier (12) est tangente à une projection orthographique d'un bord du trou traversant (130) sur le boîtier (12).

5. L'ensemble électronique (10) selon la revendication 2, dans lequel une projection orthographique du bord extérieur de la bobine (110) sur le boîtier (12) se situe à l'intérieur d'une projection orthographique de la plaque (13) conductrice de chaleur sur le boîtier (12).

6. L'ensemble électronique (10) selon la revendication 1, dans lequel le trou traversant (130) a une forme circulaire.

7. L'ensemble électronique (10) selon la revendication 6, dans lequel le trou traversant (130) a un diamètre allant de 15 mm à 25 mm.

8. L'ensemble électronique (10) selon la revendication 7, dans lequel le trou traversant (130) a un diamètre de 20 mm.

9. Un dispositif (40) formant terminal, comprenant une batterie (41) et l'ensemble électronique (10) selon l'une quelconque des revendications 1 à 8, dans lequel la batterie (41) est connectée électriquement au module électromagnétique (11), et le boîtier (12) recouvre la batterie (41).
